# EUROPÄISCHE PATENTSCHRIFT

(11) **EP 2 899 652 B1**
(45) Veröffentlichungstag und Bekanntmachung des Hinweises auf die Patenterteilung: **13.03.2024**
(21) Anmeldenummer: 14152109.6
(22) Anmeldetag: 22.01.2014
(51) Int. Cl.: G06F 30/33, G05B 17/02

(54) **Verfahren zur Einsatzoptimierung programmierbarer Logikbausteine in Steuerungsgeräten für Fahrzeuge**
Method for optimising the operation of programmable logic modules in control devices for vehicles
Procédé d'optimisation de l'utilisation de modules logiques programmables dans des appareils de commande pour véhicules

(43) Veröffentlichungstag der Anmeldung: 29.07.2015
(73) Patentinhaber: dSPACE GmbH, 33102 Paderborn (DE)
(72) Erfinder: Grajetzky, Olaf, 33442 Herzebrock-Clarholz (DE)

(56) Entgegenhaltungen:
- SEO, K., YOON, J., KIM, J., CHUNG, T., YI, K., & CHANG, N.: "Coordinated implementation and processing of a unified chassis control algorithm with multi-central processing unit", PROCEEDINGS OF THE INSTITUTION OF MECHANICAL ENGINEERS, PART D: JOURNAL OF AUTOMOBILE ENGINEERING, Bd. 224(5), 1. Mai 2010 (2010-05-01), - 1. Mai 2010 (2010-05-01), Seiten 565-586, XP009178791, DOI: doi: 10.1243/09544070JAUTO1346
- ROMAN BARTOSINSKI ET AL: "Integrated Environment for Embedded Control Systems Design", PARALLEL AND DISTRIBUTED PROCESSING SYMPOSIUM, 2007. IPDPS 2007. IEEE INTERNATIONAL, IEEE, PI, 1. März 2007 (2007-03-01), Seiten 1-8, XP031175391, ISBN: 978-1-4244-0909-9
- ZHENHUA JIANG ET AL: "Processor-in-the-loop simulation, real-time hardware-in-the-loop testing, and hardware validation of a digitally-contiolled, fuel-cell powered battery-charging station", POWER ELECTRONICS SPECIALISTS CONFERENCE, 2004. PESC 04. 2004 IEEE 35TH ANNUAL, AACHEN, GERMANY 20-25 JUNE 2004, PISCATAWAY, NJ, USA,IEEE, US, Bd. 3, 20. Juni 2004 (2004-06-20), Seiten 2251-2257, XP010739624, DOI: 10.1109/PESC.2004.1355471 ISBN: 978-0-7803-8399-9
- HANSELMANN H ET AL: "Production quality code generation from Simulink block diagrams", COMPUTER AIDED CONTROL SYSTEM DESIGN, 1999. PROCEEDINGS OF THE 1999 IE EE INTERNATIONAL SYMPOSIUM ON KOHALA COAST, HI, USA 22-27 AUG. 1999, PISCATAWAY, NJ, USA,IEEE, US, 22. August 1999 (1999-08-22), Seiten 213-218, XP010360391, DOI: 10.1109/CACSD.1999.808650 ISBN: 978-0-7803-5500-2
- JASON G TONG ET AL: "Soft-Core Processors for Embedded Systems", MICROELECTRONICS, 2006. ICM '06. INTERNATIONAL CONFERENCE ON, IEEE, PI, 1. Dezember 2006 (2006-12-01), Seiten 170-173, XP031180279, ISBN: 978-1-4244-0764-4
- DAVID SHELDON ET AL: "Application-specific customization of parameterized FPGA soft-core processors", COMPUTER-AIDED DESIGN; [IEEE/ACM INTERNATIONAL CONFERENCE ON COMPUTER-AIDED DESIGN], IEEE PRESS, 445 HOES LANE PO BOX 1331 PISCATAWAY, NJ 08855-1331 USA, 5 November 2006 (2006-11-05), pages 261-268, XP058136741, ISSN: 1092-3152, DOI: 10.1145/1233501.1233553 ISBN: 978-0-7803-7607-6

## Beschreibung

### GEBIET DER ERFINDUNG

Die Erfindung betrifft ein Verfahren sowie ein System zur Einsatzoptimierung eines programmierbaren Logikbausteins zur Verwendung in einer elektronischen Steuerungseinheit für Fahrzeuge, wobei der programmierbare Logikbaustein eine Soft-CPU und/oder eine nicht genutzte Restfläche aufweist.

Der Begriff elektronische Steuerungseinheit kann im Rahmen der vorliegenden Erfindung verstanden werden als ein Steuerungssystem, beispielsweise ein Steuergerät in einem Kraftfahrzeug. Die elektronische Steuerungseinheit kann dabei beispielsweise zum Messen, Steuern, Regeln und/oder Kalibrieren von Fahrzeugkomponenten dienen. Der Begriff Fahrzeug wird im Folgenden als umfassende Bezeichnung für Wasserfahrzeuge, Landfahrzeuge, Luftfahrzeuge, Raumfahrzeuge und/oder Kombinationen davon verwendet.

### HINTERGRUND

Elektronische Steuerungseinheiten für Fahrzeuge werden unter anderem durch die Verwendung eingebetteter Systeme, d.h. elektronischer Recheneinheiten, die in einem technischen Kontext eingebunden sind, realisiert. Zu diesem Zwecke sind verschiedenste CPU-Architekturen bekannt. Eine besonders flexible Plattform sind dabei hoch integrierte programmierbare Logikbausteine, z.B. field programmable gate arrays (FPGA), die zum einen unterschiedliche CPU-Architekturen nachbilden, zum anderen auch gut parallele Rechenleistung ohne Prozessor - nur durch Logik - ausführen können.

Die Programmierbarkeit eines Logikbausteins bezieht sich dabei nur sekundär auf die Vorgabe zeitlicher Abläufe im Logikbaustein. Primär wird damit auf die Definition grundlegender Funktionsweisen einzelner universeller Blöcke im programmierbaren Logikbaustein und deren Verschaltung untereinander abgestellt. Durch eine solche Programmierung interner Strukturen können in einem programmierbaren Logikbaustein verschiedene Schaltungen realisiert werden. Diese reichen von Schaltungen geringer Komplexität bis zu hochkomplexen Schaltungen wie Mikroprozessoren. Da ein solcher Mikroprozessor ausschließlich durch Logiksynthese realisiert/aufgebaut wird, spricht man von einer sogenannten Soft-CPU.

Ein Beispiel für eine solche Soft-CPU bietet der MicroBlaze^{™}, dessen Benutzerdokumentation unter http://www.xilinx.com/support/documentation/sw_manuals/xilinx14_1/mb_ref_guide.pdf zu finden ist. Die vorliegende Erfindung ist jedoch keineswegs auf den MicroBlaze^{™} beschränkt, sondern ist auf jede beliebige Soft-CPU anwendbar.

Je nach gewünschtem Konfigurationsumfang haben Soft-CPUs wie der MicroBlaze^{™} eine konfigurierbare drei- bis fünfstufige Pipeline, internen Cache, einen Interrupt, einen hardwarebasierten Multiplizierer und optional eine hardwarebasierende Divisionseinheit, eine Fließkommaeinheit und spezielle Schieberegistereinheiten, sowie mehrere unterschiedliche Busse, welche für den Anschluss von umfangreicher Peripherie und Speicher in einem programmierbarer Logikbaustein vorgesehen sind. Bei einer Flächen-optimierten Variante des MicroBlaze^{™}, welche eine dreistufige Pipeline benutzt, wird die Taktfrequenz zu Gunsten eines verringerten Bedarfes an Logik-Fläche reduziert. Anders bei der Leistungs-optimierten Version, in der eine fünfstufige Pipeline verwendet wird, welche Taktraten bis 210MHz erlaubt, dementsprechend aber auch größere Fläche in Anspruch nimmt.

Desweiteren kann die Soft-CPU so konfiguriert werden, dass Kernprozessor-Operationen, welche selten benutzt werden und hardwareseitig aufwendig zu implementieren sind, zur Soft-CPU hinzugefügt werden (z.B. multiplizieren, dividieren oder Fließkomma-Operationen). Aus dem Konferenzartikel "Application-Specific Customization of Parameterized FPGA Soft-Core Processors", ICCAD'06, November 5-9, 2006, San Jose, Kalifornien, von D. Sheldon et al. ist es bekannt, für verschiedene Benchmark-Programme jeweils eine optimale Konfiguration einer Soft-CPU zu ermitteln, indem verschiedene Konfigurationen der Soft-CPU synthetisiert, die Programme auf den verschiedenen Konfigurationen ausgeführt und Profiling-Informationen erfasst werden.

Je nach Konfiguration der Soft-CPU ergibt sich der Umfang an frei programmierbarer Fläche des programmierbaren Logikbausteins, welche von der Soft-CPU eingenommen wird. Wird der Umfang an frei programmierbarer Chipfläche eines programmierbaren Logikbausteins durch eine benötigte Konfiguration - mit oder ohne Soft-CPU - zur Bereitstellung eines bestimmten Befehlssatzes an ausführbaren Rechenoperationen nicht ausgeschöpft, verbleiben Teile des programmierbaren Logikbausteins ungenutzt. Im Rahmen der vorliegenden Erfindung wird der Restbestand an frei programmierbarer Chipfläche daher als ungenutzte Restfläche des programmierbaren Logikbausteins bezeichnet.

Des Weiteren gehört es zur gängigen Praxis in der Entwicklung elektronischer Steuerungseinheiten entsprechend des jeweiligen Entwicklungsstadiums modellbasierte Simulationen zum Testen bestimmter Steuerungs- und Regelungsmechanismen für eine elektronische Steuerungseinheit durchzuführen. Die angestrebten Steuerungs- und Regelungsfunktionen werden dabei zunächst in einem Modell abgebildet. Auf Basis des modellbasierten Designs wird dann Programmcode bzw. eine Software generiert, die die zuvor modellierten Funktionen gemäß der entsprechenden Modellvariante umsetzt. In einem frühen Entwicklungsstadium wird erst das Modell und dann die Software in so genannten Modell- und Software-in-the-loop (MIL/SIL) Simulationsverfahren getestet, um Abweichungen zwischen Modell- und Programmcode/Software-Verhalten zu erkennen. Wird der Programmcode zusätzlich auf einem realen Prozessorkern ausgeführt, spricht man von einem/einer Processor-in-the-loop (PIL) -Verfahren bzw. -Simulation. Durch diese PIL-Simulationen lassen sich Engpässe, Fehler oder nicht realisierbare Prozesse frühzeitig erkennen. PIL-Simulationen und die dabei anfallenden Profiling-Daten sind im Stand der Technik bekannt und z.B. ausführlich in der Dokumentation einschlägiger Programme zum modellbasierten Softwaredesign wie z.B. TargetLink beschrieben.

In späteren Entwicklungsstadien werden Teile der Hardware, welche bereits realisiert wurden (zum Beispiel ein reales elektronisches Steuergerät für ein Fahrzeug als eingebettetes System), mithilfe von modellbasierten, simulierten Eingangssignalen auf ihre korrekte Funktionsweise in so genannten Hardware-in-the-loop (HIL) Verfahren getestet. Beispielsweise ist in dem gattungsgemäßen Artikel "Coordinated implementation and processing of a unified chassis control algorithm with multi-central processing unit", Proceedings ofthe Institution of Mechanical Engineers, Part D: Journal of Automobile Engineering, Vol. 224 (Mai 2010), Seiten 565-586 eine Hardware-in-the-loop Simulation eines Chassis Controllers beschrieben, der eine Fahrdynamikregelung mittels Lenk- und Bremseingriffen bereitstellt. Auf einem programmierbaren Logikbaustein werden parallel drei Soft-CPUs ausgeführt, wobei der Regelalgorithmus in verschiedenen Varianten unterschiedlich auf die einzelnen Soft-CPUs verteilt wird und Profiling-Daten ermittelt werden.

Mit fortschreitendem Entwicklungsstadium nimmt der Aufwand für Testaufbauten und Testdurchführung zu und die Flexibilität der Einsatzweise der zu testenden Systeme ab. Es ist daher wünschenswert, modellbasiertes Design für Steuerungseinheiten bereits frühzeitig im Hinblick auf Hardware-basierte Rahmenbedingungen/Gegebenheiten abzustimmen.

### DIE ERFINDUNG IM ÜBERBLICK

Aufgabe der vorliegenden Erfindung ist es, ein Verfahren und System bereitzustellen, welches geeignet ist, den Einsatz eines programmierbaren Logikbausteins zur Verwendung in einer elektronischen Steuerungseinheit zu optimieren, wobei der programmierbare Logikbaustein eine Soft-CPU und/oder eine nicht genutzte Restfläche aufweist.

Die Aufgabe wird gelöst durch ein Verfahren der eingangs genannten Art, welches die folgenden Schritte umfasst:
Erstellen einer Vielzahl von Modellvarianten, welche die Funktionalität der Steuerungseinheit abbilden, wobei die Modellvarianten sich im Umfang der von einer Soft-CPU durchzuführenden Rechenoperationen unterscheiden;

Erstellen einer Vielzahl von Soft-CPU-Konfigurationen mit unterschiedlichem Konfigurationsumfang, die eine dem Konfigurationsumfang entsprechende Fläche des programmierbaren Logikbausteins einnehmen;

Durchführen von Processor-in-the-loop-Simulationen für die Vielzahl von Modellvarianten und/oder Soft-CPU-Konfigurationen, wobei das Durchführen für jede Kombination aus Modellvariante und Soft-CPU-Konfiguration beinhaltet:
Instanziieren der Soft-CPU entsprechend der Soft-CPU-Konfiguration auf einem programmierbaren Logikbaustein, welcher sich auf einer Entwicklungsleiterplatte befindet, die mit einem Computer verbunden ist, wobei ein der Modellvariante entsprechender Programmcode vom Computer auf die Soft-CPU heruntergeladen wird;
Ausführen eines Simulationsprogramms, wobei ein gemäß Modellvariante von der Soft-CPU zu verarbeitendes Signal simuliert und über eine entsprechende Schnittstelle vom Computer zur der auf dem programmierbaren Logikbaustein programmierten Soft-CPU übertragen wird,
Verarbeiten des Eingangssignals durch die Soft-CPU;
Erfassen und Speichern von Profiling-Daten der Soft-CPU hinsichtlich der Verarbeitung des Eingangssignals;
Übertragen des verarbeiteten Signals sowie der Profiling-Daten vom programmierbaren Logikbaustein zum Computer.

Erfindungsgemäß werden Processor-in-the-Loop-Simulationen durchgeführt, wobei eine Vielzahl von Soft-CPU-Konfigurationen mit unterschiedlichem Konfigurationsumfang erstellt werden, und für verschiedene Kombinationen aus Modellvariante und Soft-CPU-Konfigurationen Simulationen durchgeführt werden. Weiterhin wird der Schritt eines Ermittelns, ob die in der Modellvariante abgebildete Funktionalität allein von dem programmierbaren Logikbaustein in Echtzeit und mit einer erforderlichen Genauigkeit berechnet werden kann durchgeführt, wobei als Bewertungsgrundlage die erfassten Profiling-Daten dienen. Die Profiling-Daten umfassen mindestens eine der Größen Auslastung des RAM- und/oder ROM-Speichers, Auslastung des Stack, benötigte Ausführungszeit oder Genauigkeit der Rechenoperation.

Der Erfindung liegt die Erkenntnis zu Grunde, dass sich die von einer Soft-CPU benötigte Fläche des programmierbaren Logikbausteins nach der von der Soft-CPU zu erfüllenden Aufgabe, d.h. Rechenoperation, richtet. Je umfangreicher die Funktionalität, die von der Soft-CPU zur Verfügung gestellt wird, desto mehr Fläche wird sie auf dem programmierbaren Logikbaustein einnehmen. Mit dem erfindungsgemäßen Verfahren lässt sich die optimale Konfiguration einer Soft-CPU unter dem Gesichtspunkt des modellgemäßen Rechenumfanges, der Rechengenauigkeit und dem benötigten Konfigurationsumfang der Soft-CPU und damit der Fläche auf dem programmierbaren Logikbaustein ermitteln.

Dies ist in der folgenden Situation bei der Entwicklung von Steuergeräten attraktiv:
- Ein programmierbarer Logikbaustein wird ohnehin benötigt und weist noch einen Restbestand an frei programmierbarer Fläche auf, die derzeit noch ungenutzt ist. Hier ist die Nutzung der Restfläche als Soft-CPU möglich.
- Ein programmierbarer Logikbaustein mit einer Soft-CPU wird ohnehin benötigt und es gilt nun abzuwägen, ob bzw. wie viel zusätzliche programmierbare Fläche des programmierbaren Logikbausteins für die Soft-CPU zur Verfügung gestellt werden kann/muss.
- Algorithmische Funktionalitäten werden modellbasiert entworfen und müssen auf dem Steuergerät ausgeführt werden. Die Ausführung auf einem Mikrocontroller scheidet jedoch aus, weil entweder kein Mikrocontroller vorhanden ist (sondern nur ein programmierbarer Logikbaustein) oder auf dem Mikrocontroller keine Ressourcen mehr frei sind, um die gesamte algorithmische Funktionalität auszuführen.

In Situationen wie den vorstehend aufgeführten ist es attraktiv, die Restfläche des programmierbaren Logikbausteins effizient zu nutzen, um auf ihr eine Soft-CPU und die benötigten HardwareRessourcen (Speicher etc.) zu instanziieren, so dass einem jeweiligen Modell einer Steuerungseinheit entsprechend generierter Programmcode auf die Soft-CPU heruntergeladen und dort entsprechend ausgeführt werden kann. Alternativ lassen sich so ggf. Ressourcen einer bereits vorliegenden Soft-CPU ausnutzen und/oder erweitern.

Zur Ermittlung des optimalen Einsatzes erhält man mit Hilfe der vorliegenden Erfindung durch Processor-in-the-Loop-Simulationen mit der Soft-CPU als Zielplattform genaue Profiling-Daten, welche Rückschlüsse auf die Leistung bzw. Effizienz der Soft-CPU bei der Verarbeitung der Eingangssignale entsprechend dem heruntergeladenen Programmcode erlauben. Die Konfiguration der Soft-CPU kann dabei entsprechend der zur Verfügung stehenden Fläche auf dem programmierbaren Logikbaustein variiert und mit verschiedenen Varianten des von der Soft-CPU auszuführenden Programmcodes kombiniert werden, wobei sich dieser sowohl im allgemeinen Umfang der Funktionalität sowie in der Genauigkeit der Berechnung der Rechenoperationen unterscheiden kann. Daneben ist es auch möglich durch entsprechende Konfiguration des Modells der Steuerungseinheit durch Programme wie z.B TargetLink, durch Änderungen direkt am Modell oder mit Hilfe eines Data Dictionary, eine optimale Ausnutzung der vorhandenen Kapazität der Soft-CPU bzw. der Restfläche auf dem programmierbaren Logikbaustein zu erreichen. TargetLink oder ein äquivalentes Programm kann dabei genutzt werden, um den Programmcode derart zu erzeugen, dass er optimal auf einer (gegebenen) Soft-CPU ausgeführt werden kann. So lassen sich mit der vorliegenden Erfindung folgende Vorteile realisieren:
- Wenn ein programmierbarer Logikbaustein mit vorhandener Restfläche existiert, dann kann diese durch die Erfindung auf sehr einfache Weise sinnvoll und optimal genutzt werden.
- Wenn ein programmierbarer Logikbaustein mit Soft-CPU vorhandenen ist, kann deren freie Rechenkapazität durch die Erfindung auf sehr einfache Weise sinnvoll und optimal genutzt werden.
- Man kann Mikrocontroller einsparen, sofern ein programmierbarer Logikbaustein vorhanden ist, der dieselbe Funktionalität ausreichend effizient und schnell berechnen kann.
- Die PIL-Anbindung, d.h. die Schnittstellenbeschreibung für die Soft-CPUs wird man in vielen Fällen (für unterschiedliche Soft-CPUs) wiederverwenden können.

In einer bevorzugten Ausführungsform der vorliegenden Erfindung unterscheiden sich die Soft-CPU-Konfigurationen in Bezug auf eine Verwendung von Festkomma- (fixed-point) oder Fließkomma-(floating-point) Operationen.

In einer weiteren bevorzugten Ausführungsform der vorliegenden Erfindung unterscheiden sich die Soft-CPU-Konfigurationen in Bezug auf Cache für Instruktionen und Daten und/oder die Länge der Pipelines.

In einer weiteren bevorzugten Ausführungsform der vorliegenden Erfindung unterscheiden sich die Soft-CPU-Konfigurationen in Bezug auf eine Verwendung arithmetischer und logischer Grundoperationen.

Eine weitere bevorzugte Ausführungsform der vorliegenden Erfindung beinhaltet weiter die Schritte:
- automatische Auswahl einer optimalen Soft-CPU-Konfiguration und der entsprechenden Modellvariante gemäß vorbestimmter Kriterien bezüglich des Konfigurationsumfang der Soft-CPU und der Profiling-Daten,
- passgenaue Codegenerierung eines entsprechenden Steuergeräteprogrammcodes an Hand der ausgewählten Modellvariante.

Anstatt eine ausgewählte Anzahl von Modellvarianten zur Auswahl zu stellen, können automatisch sämtliche Permutationen durchgespielt werden. Anhand der Profiling-Daten kann dann ebenfalls automatisch nach vorgegebenen Kriterien eine automatische Auswahl der optimalen Variante erfolgen.

Ein weiterer Aspekt der vorliegenden Erfindung ist ein System zum Ermitteln einer optimalen Einsatzkonfiguration eines programmierbaren Logikbausteins zur Verwendung in einer elektronischen Steuerungseinheit für Fahrzeuge. Das System umfasst einen programmierbaren Logikbaustein, welcher sich auf einer Entwicklungsleiterplatte befindet und eine Soft-CPU und/oder eine nicht genutzte Restfläche aufweist, einen Computer zum Ausführen eines Simulationsprogramms entsprechend einer Modellvariante der elektronischen Steuerungseinheit, wobei das Simulationsprogramm die Funktionalität der Steuerungseinheit abbildet und Eingangssignale simuliert, welche von einer Soft-CPU auf dem programmierbaren Logikbaustein zu verarbeiten sind. Ferner umfasst das System Mittel zum Instanziieren einer Soft-CPU mit einem bestimmten Konfigurationsumfang auf dem programmierbaren Logikbaustein, wobei die Soft-CPU eine dem Konfigurationsumfang entsprechende Fläche des programmierbaren Logikbausteins einnimmt, Mittel zum Herunterladen eines der Modellvariante entsprechenden Programmcodes vom Computer auf die Soft-CPU; Mittel zum Übertragen eines bei Ausführen des Simulationsprogramms erzeugten Eingangssignals vom Computer an die auf dem programmierbaren Logikbaustein instanziierte Soft-CPU zur Verarbeitung, Mittel zum Erfassen von Profiling-Daten der Soft-CPU bezüglich der Verarbeitung des Eingangssignals; und Mittel zum Übertragen eines durch Verarbeitung des Eingangssignals von der Soft-CPU erhaltenes Rechenergebnisses sowie der erfassten Profiling-Daten von der Soft-CPU an den Computer.

Die Mittel zum Herunterladen und Übertragen von Daten zwischen der auf dem programmierbaren Logikbaustein instanziierten Soft-CPU und dem Computer, welcher als Host-PC für die Simulationen dient, können zum Beispiel durch serielle und/oder Ethernet-Schnittstellen zum gegenseitigen Datenaustausch realisiert werden. So kann ein Simulationsprogramm auf dem Computer der Modellvariante für die Steuerungseinheit entsprechende Eingangssignale an den programmierbaren Logikbaustein auf der Entwicklungsleiterplatte, insbesondere an die instanziierte Soft-CPU, ausgeben. Nach der Ausführung der jeweiligen Rechenschritte des auf der Soft-CPU implementierten Prorammcodes durch die Soft-CPU werden neben dem erzielten Rechenergebnis, welches zur weiteren Verwendung an das Simulationsprogramm zurückgegeben wird auch dabei ermittelte Profiling-Daten über die Schnittsteller an den Host-PC zurück geliefert. Durch die Rückgabe des erzielten Rechenergebnisses an das Simulationsprogramm ergibt sich ein geschlossener Simulationskreis, der einen Streckenalogrithmus auf dem Host-PC und den auf der Soft-CPU ausgeführten, modellbasiert erzeugten Programmcode umfasst. Die für die beidseitige Übertragung des Eingangs- sowie Ergebnissignals benötigten Mittel des programmierbaren Logikbausteins können ebenfalls für die Übertragung der Profiling-Daten verwendet werden, welche vorher für die Soft-CPU bei der gemäß Modellvariante entsprechenden Verarbeitung des Eingangssignals ermittelt und gegebenenfalls zwischengespeichert wurden.

Der Logikbaustein kann dabei eine ungenutzte Restfläche aufweisen. Die Soft-CPU-Konfiguration definiert dabei den Umfang der benötigten Hardware-Ressourcen sowie den Befehlsumfang, welcher von der Soft-CPU bearbeitet werden kann. Das System kann verschiedene Modellvarianten der Steuerungseinheit bei der gleichen Soft-CPU-Konfiguration testen oder auch eine Modellvariante auf verschiedenen Soft-CPU-Konfigurationen, wobei dabei eine Anpassung der entsprechenden Soft-CPU-Konfiguration von Nöten sein kann und eine eventuelle Restfläche des programmierbaren Logikbausteins für zusätzliche Caches und Pipelines sowie eine Erweiterung des Befehlssatzes genutzt werden kann. Die Schnittstellenkonfiguration zwischen dem auf der Entwicklungsleiterplatte befindlichen programmierbaren Logikbaustein und dem Host-PC kann dabei ohne Veränderungen für verschiedene Kombinationen aus Modellvarianten und Soft-CPU-Konfiguration verwendet werden.

### BESCHREIBUNG DER ZEICHNUNGEN

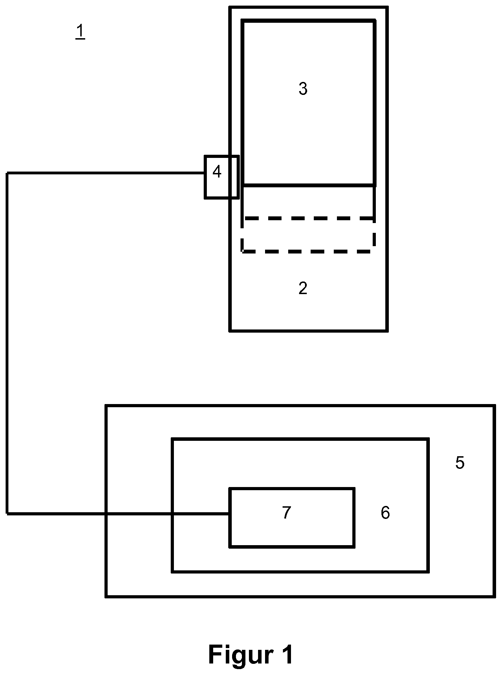

Figur 1 zeigt den systematischen Aufbau einer bevorzugten Ausführungsform des erfindungsgemäßen Systems.

### DETAILLIERTE BESCHREIBUNG

Im Fokus der vorliegenden Erfindung steht die Anwendung von Processor-in-the-Loop (PIL) Simulationen auf eine "Soft-CPU" als Zielplattform (statt einem physikalischen Mikrocontroller als Zielhardware), wobei die Soft-CPU auf einem programmierbaren Logikbaustein instanziiert ist. In den PIL-Simulationen können Profiling-Daten gewonnen werden, welche Aufschluss über die Auslastung, Leistung und Effizienz der Soft-CPU beim Ausführen eines auf der Soft-CPU implementierten Programmcodes geben. Der auszuführende Programmcode bestimmt sich dabei durch ein zugrunde gelegtes Modell der Steuerungseinheit, welches die Funktionalität einer elektronischen Steuerungseinheit abbildet und auf dessen Basis durch Programme wie z.B. TargetLink automatisch entsprechend dem jeweiligen modellbasierten Design der von der Soft-CPU auszuführende Programmcode erzeugt werden kann. Durch Variieren der Soft-CPU Konfiguration und/oder des Modells der Steuerungseinheit und damit des von der Soft-CPU auszuführenden Programmcodes kann somit eine optimale Konfiguration der Soft-CPU und/oder eine Optimierung des modellbasierten Programmcodes bzw. eine optimale Kombination der beiden ermittelt werden. Der Optimierungsprozess kann also beidseitig ablaufen.

Auf der einen Seite werden verschiedene Soft-CPU-Konfigurationen mit unterschiedlichem Konfigurationsumfang auf dem programmierbaren Logikbaustein instanziiert, auf der anderen Seite kann der Funktionsumfang des modellbasiert generiertem und auf der Soft-CPU implementierte Programmcodes variiert werden.

Mit anderen Worten, es wird nicht nur die Konfiguration einer Soft-CPU für ein festes Modell einer Steuerungseinheit optimiert, sondern auch das Modell der Steuerungseinheit bzw. der auf dem Modell basierende und später von der Steuerungseinheit auszuführende Programmcode kann variiert werden, um eine umfassende optimale Ausnutzung der vorhandenen frei programmierbaren Fläche des programmierbaren Logikbaustein und einer auf diesem instanziierten Soft-CPU und entsprechender Hardwareressourcen (Speicher, Pipelines usw.) zu ermöglichen. Die so ermittelte, optimal konfigurierte Soft-CPU wird dann später auf dem programmierbaren Logikbaustein einer Steuerungseinheit instanziiert und führt den aus dem modellbasierten Design generierten Programmcode aus.

Das Modelldesign kann dabei mit TargetLink durch Änderungen am Modell und/oder im TargetLink Data Dictionary variiert werden. Die Optimierung kann daher als ein Abwägen zwischen Leistung versus Genauigkeit versus frei programmierbare Fläche des programmierbaren Logikbausteins erfolgen.

Figur 1 zeigt schematisch eine bevorzugte Ausführungsform des erfindungsgemäßen Systems 1, bei welchem ein Host-PC 5 seriell und/oder über Ethernet mit einem auf einer Entwicklungsleiterplatte befindlichen programmierbaren Entwicklungs-Logikbaustein 2 verbunden ist. Auf dem programmierbaren Logikbaustein ist ein Soft-CPU instanziiert, welche ja nach gewünschtem Konfigurationsumfang eine entsprechende Fläche des programmierbaren Logikbausteins einnimmt. Die Schnittstelle 4 zum programmierbaren Entwicklungs-Logikbaustein kann z.B. in VHDL beschrieben sein. Das so ausgestaltete System ermöglicht die Durchführung von PIL-Simulationen mit der Soft-CPU als Zielplattform.

Der Ablauf einer PIL-Simulation ist dabei wie folgt:
Auf dem Host-PC 5 wird ein Streckenmodell (als Fahrzeug mit Umwelt) simuliert. Die Modellation kann dabei unter Verwendung von Programmen 6 wie Matlab/Simulink erfolgen, welche es mithilfe geeigneter Tools möglichen, aus dem Modell heraus fertigen Code (C und VHDL) für Mikroprozessoren, Computer und programmierbare Logikbausteine zu erzeugen. Zusammen mit einem weiteren Programmteil - hier S-Funktion genannt - 7 bildet das Streckenmodell einen geschlossenen Regelkreis. Die S-Funktion 7 fungiert dabei als Platzhalter für das eigentlich an diese Stelle gehörende Modell der Steuerungseinheit. Sie dient damit als Kommunikationsschnittstelle des Regelkreises mit der Soft-CPU 3. Diese ist entsprechend einer bestimmten Soft-CPU Konfiguration auf einem programmierbaren Entwicklungs-Logikbaustein 2 instanziiert, zusammen mit darüber hinaus benötigter Logik, um aus dem programmierbaren Entwicklungs-Logikbaustein eine PIL-Zielplattform zu machen. Hierzu muss einerseits eine Verbindung zu einem Host-PC 5 realisiert werden, z.B. durch eine serielle Verbindung bzw Ethernetverbindung. Andererseits muss Logik bereitgestellt werden, um die notwendigen Profiling-Daten wie z.B. Auslastung RAM, Auslastung ROM, Auslastung Stack oder auch die Ausführungszeit bei der Durchführung der PIL-Simulation aufzunehmen. Sowohl auf dem Entwicklungs-Logikbaustein instanziierte generische Anteile einer Soft-CPU zur Verarbeitung von Profiling-Daten sowie die Verbindung zum Host-PC 5 können in jedem Projekt/Test wiederverwendet werden.

Der gemäß Modellvariante generierte Programmcode wird auf die Soft-CPU 3 geladen. Die S-Funktion 7 sendet einen Satz Eingangssignale an die Soft-CPU 3. Dort wird entsprechend der implementierten Rechenschritte ein Regleralgorithmus ausgeführt, dessen Ergebnis an die S-Funktion 7 zurückgegeben wird. In Reaktion auf das erhaltene Rechenergebnis liefert die S-Funktion 7 wiederum neue Eingangssignale für einen nächsten Rundlauf.

Neben dem Rechenergebnis werden auch Profiling-Daten an den Host-PC übermittelt. Diese erlauben einen Rückschluss auf die Leistung der Soft-CPU beim Durchführen der Rechenschritte.

Die PIL-Simulationen werden für verschiedene Modellvarianten und/oder Soft-CPU-Konfiguration mit unterschiedlichem Konfigurationsumfang durchgeführt und jeweils die entsprechenden Profiling-Daten ermittelt. Es können parallel oder nacheinander verschiedene Konfigurationen der Soft-CPU und des TargetLink-Modells durchgespielt werden. Beim Durchlaufen der Simulationen mit unterschiedlichen Soft-CPU Konfigurationen und/oder Modellvarianten muss ein Ausgleich zwischen den beiden gegensätzlichen Anforderungen gefunden werden:
- RAM/ROM/Stack bzw. die Rechenleistung, die aus der Soft-CPU-Konfiguration resultiert, müssen bei der gegebenen Soft-CPU Konfiguration hinreichend bemessen sein, um die Funktionalität auf der Soft-CPU rechnen zu können.
- Die Soft-CPU inklusive der obigen Ressourcen muss auf der Restfläche des eigentlichen programmierbaren Logikbausteins der Steuerungseinheit Platz finden oder der zu berechnende Algorithmus muss in der noch freien Rechenkapazität des Soft-CPU in Echtzeit ausführbar sein.

Nach mehrfachem Durchlauf der PIL-Simulationen für unterschiedliche Soft-CPU-Konfigurationen mit unterschiedlichem Konfigurationsumfang und/oder Modellvarianten für die Steuerungseinheit, wird schließlich diejenige Soft-CPU auf dem programmierbaren Logikbaustein der Steuerungseinheit oder einer auf dem programmierbaren Logikbaustein verbleibenden Restfläche instanziiert und der entsprechende Programmcode dort ausgeführt, welcher die vorstehenden, gegensätzlichen Anforderungen optimal abwägt. Als Bewertungsgrundlage dienen dabei die jeweils ermittelten Profiling-Daten. Dabei wird das Verfahren und System genutzt, um zu ermitteln, ob ein bestimmter Prozess allein von einem programmierbaren Logikbaustein in Echtzeit und mit einer erforderlichen Genauigkeit berechnet werden kann und so gegebenenfalls auf einen Mikrocontroller verzichtet werden kann.

## Patentansprüche

1. Verfahren zur Einsatzoptimierung eines programmierbaren Logikbausteins zur Verwendung in einer elektronischen Steuergeräteeinheit für Fahrzeuge, wobei der programmierbare Logikbaustein eine Soft-CPU und/oder eine nicht genutzte Restfläche aufweist, und wobei das Verfahren die folgenden Schritte aufweist:
Erstellen einer Vielzahl von Modellvarianten, welche die Funktionalität der elektronischen Steuerungseinheit abbilden, wobei die Modellvarianten sich im Umfang der von einer Soft-CPU durchzuführenden Rechenoperationen unterscheiden;
Erstellen einer Soft-CPU-Konfiguration, die eine dem Konfigurationsumfang entsprechende Fläche des programmierbaren Logikbausteins einnimmt;
Durchführen von Simulationen für verschiedene Modellvarianten, wobei das Durchführen für jede Modellvariante beinhaltet:
Instanziieren der Soft-CPU entsprechend der Soft-CPU-Konfiguration auf einem programmierbaren Logikbaustein, welcher sich auf einer Entwicklungsleiterplatte befindet, die mit einem Computer verbunden ist, wobei ein der Modellvariante entsprechender Programmcode vom Computer auf die Soft-CPU heruntergeladen wird;
Ausführen eines Simulationsprogramms, wobei ein gemäß Modellvariante von der Soft-CPU zu verarbeitendes Signal simuliert und über eine entsprechende Schnittstelle vom Computer zur der auf dem programmierbaren Logikbaustein programmierten Soft-CPU übertragen wird,
Verarbeiten des Eingangssignals durch die Soft-CPU;
Erfassen und Speichern von Profiling-Daten der Soft-CPU hinsichtlich der Verarbeitung des Eingangssignals, **dadurch gekennzeichnet,**
**dass** Processor-in-the-Loop-Simulationen durchgeführt werden,
**dass** eine Vielzahl von Soft-CPU-Konfigurationen mit unterschiedlichem Konfigurationsumfang erstellt werden, dass für verschiedene Kombinationen aus Modellvariante und Soft-CPU-Konfigurationen Simulationen durchgeführt werden,
wobei die Profiling-Daten mindestens eine der Größen Auslastung des RAM- und/oder ROM-Speichers, Auslastung des Stack, benötigte Ausführungszeit oder Genauigkeit der Rechenoperation umfassen, und
**dass** weiterhin der Schritt eines Ermittelns, ob die in der Modellvariante abgebildete Funktionalität allein von dem programmierbaren Logikbaustein in Echtzeit und mit einer erforderlichen Genauigkeit berechnet werden kann durchgeführt wird, wobei als Bewertungsgrundlage die erfassten Profiling-Daten dienen.

2. Verfahren zur Einsatzoptimierung eines programmierbaren Logikbausteins in einer elektronischen Steuerungseinheit für Fahrzeuge nach einem der vorangegangenen Ansprüche, wobei die Soft-CPU-Konfigurationen sich in Bezug auf eine Verwendung von Festkomma oder Fließkomma-Operationen unterschieden.

3. Verfahren zur Einsatzoptimierung eines programmierbaren Logikbausteins in einer elektronischen Steuerungseinheit für Fahrzeuge nach einem der vorangegangenen Ansprüche, wobei die Soft-CPU-Konfigurationen sich in Bezug auf Cache für Instruktionen und Daten und/oder die Länge der Pipelines unterscheiden.

4. Verfahren zur Einsatzoptimierung eines programmierbaren Logikbausteins in einer elektronischen Steuerungseinheit für Fahrzeuge nach einem der vorangegangenen Ansprüche, wobei die Soft-CPU-Konfigurationen sich in Bezug auf eine Verwendung verschiedener arithmetischer und logischer Grundoperationen unterscheiden.

5. Verfahren zur Einsatzoptimierung eines programmierbaren Logikbausteins in einer elektronischen Steuerungseinheit für Fahrzeuge nach einem der vorangegangenen Ansprüche, wobei das Verfahren ferner umfasst:
automatische Auswahl einer optimalen Soft-CPU-Konfiguration und der entsprechenden Modellvariante gemäß vorbestimmter Kriterien bezüglich des Konfigurationsumfangs der Soft-CPU und der Profiling-Daten, passgenaue Codegenerierung eines entsprechenden Steuergeräteprogrammcodes an Hand der ausgewählten Modellvariante.

6. System zum Ermitteln einer optimalen Einsatzkonfiguration eines programmierbaren Logikbausteins zur Verwendung in einer elektronischen Steuerungseinheit für Fahrzeuge umfassend:
einen programmierbaren Logikbaustein, welcher sich auf einer Entwicklungsleiterplatte befindet und eine Soft-CPU und/oder eine nicht genutzte Restfläche aufweist;
einen Computer zum Ausführen eines Simulationsprogramms entsprechend einer Modellvariante der Steuerungseinheit, wobei das Simulationsprogramm die Funktionalität der Steuerungseinheit abbildet und Eingangssignale simuliert, welche von einer Soft-CPU auf dem programmierbaren Logikbaustein zu verarbeiten sind;
Mittel zum Instanziieren einer Soft-CPU mit einem bestimmten Konfigurationsumfang auf dem programmierbaren Logikbaustein, wobei die Soft-CPU eine dem Konfigurationsumfang entsprechende Fläche des programmierbaren Logikbausteins einnimmt, Mittel zum Herunterladen eines der Modellvariante entsprechenden Programmcodes vom Computer auf die Soft-CPU;
Mittel zum Übertragen eines bei Ausführen des Simulationsprogramms erzeugten Eingangssignals vom Computer an die auf dem programmierbaren Logikbaustein instanziierte Soft-CPU zur Verarbeitung;
Mittel zum Erfassen von Profiling-Daten der Soft-CPU bezüglich der Verarbeitung des Eingangssignals;
Mittel zum Übertragen der erfassten Profiling-Daten von der Soft-CPU an den Computer;
**gekennzeichnet durch**
Mittel zum Erstellen einer Vielzahl von Soft-CPU-Konfigurationen mit unterschiedlichem Konfigurationsumfang,
Mittel zur Durchführung von Processor-in-the-Loop-Simulationen für verschiedene Kombinationen aus Modellvariante und Soft-CPU-Konfigurationen, und
Mittel zum Ermitteln, ob die in der Modellvariante abgebildete Funktionalität allein von dem programmierbaren Logikbaustein in Echtzeit und mit einer erforderlichen Genauigkeit berechnet werden kann, wobei als Bewertungsgrundlage die erfassten Profiling-Daten dienen, wobei die Profiling-Daten mindestens eine der Größen Auslastung des RAM-und/oder ROM-Speichers, Auslastung des Stack, benötigte Ausführungszeit oder Genauigkeit der Rechenoperation umfassen.

## Claims

1. A method for optimizing the application of a programmable logic device for use in an electronic control device for vehicles, the programmable logic device comprising a soft CPU and/or an unused remaining space, and the method comprising the following steps:
creating a plurality of model variants mapping the functionality of the electronic control unit, the model variants differing in the scope of arithmetic operations to be performed by a soft CPU;
creating a soft CPU configuration occupying a space of the programmable logic device corresponding to the scope of configuration;
performing simulations for different model variants, the performing comprising the following for each model variant:
instantiating the soft CPU according to the soft CPU configuration on a programmable logic device present on a developmental circuit board connected to a computer, a program code corresponding to the model variant being downloaded from the computer onto the soft CPU;
performing a simulation program, a signal to be processed by the soft CPU being simulated according to the model variant and being transferred by means of a corresponding interface from the computer to the soft CPU programmed on the programmable logic device,
processing of the input signal by the soft CPU;
capturing and saving profiling data of the soft CPU with respect to processing the input signal, **characterized in that**
processor-in-the-loop simulations are performed,
a plurality of soft CPU configurations having different scope of configuration are created, simulations are performed for various combinations of model variants and soft CPU configurations,
wherein the profiling data comprise at least one of the parameters of utilization of the RAM and/or ROM memory; utilization of the stack; required execution time; or precision of the arithmetic operation; and
the step of determining whether the functionality represented in the model variant can be calculated solely by the programmable logic device, in real time, at a required precision, is performed, wherein the captured profiling data serve as the basis for evaluating.

2. The method for optimizing the application of a programmable logic device for use in an electronic control device for vehicles according to any one of the preceding claims, wherein the soft CPU configurations differ with respect to the use of fixed or floating point operations.

3. The method for optimizing the application of a programmable logic device for use in an electronic control device for vehicles according to any one of the preceding claims, wherein the soft CPU configurations differ with respect to cache for instructions and data and/or the length of the pipelines.

4. The method for optimizing the application of a programmable logic device for use in an electronic control device for vehicles according to any one of the preceding claims, wherein the soft CPU configurations differ with respect to using different arithmetic and logical unit operations.

5. The method for optimizing the application of a programmable logic device for use in an electronic control device for vehicles according to any one of the preceding claims, the method further comprising:
automatically selecting an optimal soft CPU configuration and the corresponding model variant according to predetermined criteria with respect to the scope of configuration of the soft CPU and the profiling data, and generating precision code of a corresponding control device program code using the selected model variant.

6. A system for determining an optimal application configuration of a programmable logic device for use in an electronic control unit for vehicles, comprising:
a programmable logic device present on a developmental circuit board and comprising a soft CPU and/or an unused remaining space;
a computer for executing a simulation program according to a model variant of the control unit, the simulation program mapping the functionality of the control unit and simulating input signals to be processed by a soft CPU on the programmable logic device;
means for instantiating a soft CPU having a particular scope of configuration on the programmable logic device, the soft CPU occupying a space of the programmable logic device corresponding to the scope of configuration; means for downloading a program code corresponding to one of the model variants from the computer to the soft CPU;
means for transferring an input signal generated when executing the simulation program from the computer to the soft CPU instantiated on the programmable logic device for processing;
means for capturing profiling data of the soft CPU with respect to processing the input signal;
means for transferring the captured profiling data from the soft CPU to the computer;-
**characterized by**
means for creating a plurality of soft CPU configurations having different scope of configuration,
means for performing processor-in-the loop simulations for various combinations of model variants and soft CPU configurations, and
means for determining whether the functionality represented in the model variant can be calculated solely by the programmable logic device, in real time, at a required precision, wherein the captured profiling data serve as the basis for evaluating, wherein the profiling data comprise at least one of the parameters of utilization of the RAM and/or ROM memory; utilization of the stack; required execution time; or precision of the arithmetic operation.

## Revendications

1. Procédé pour l'optimisation du déploiement d'un module logique programmable destiné à être utilisé dans une unité d'appareil de commande électronique pour véhicules, le module logique programmable comprenant une unité centrale de traitement logicielle et/ou une surface résiduelle non utilisée, et le procédé comprenant les étapes suivantes :
créer une pluralité de variantes de modèles qui représentent la fonctionnalité de l'unité de commande électronique, les variantes de modèles se différenciant par l'étendue des opérations de calcul à effectuer par une unité centrale de traitement logicielle ;
créer une configuration d'unité centrale de traitement logicielle qui occupe une surface du composant logique programmable correspondant à l'étendue de configuration ;
exécuter des simulations pour différentes variantes de modèles, l'exécution comprenant pour chaque variante de modèle :
instancier l'unité centrale de traitement logicielle de manière correspondant à la configuration de l'unité centrale de traitement logicielle sur un module logique programmable qui est disposé sur une carte imprimée de développement qui est connectée à un ordinateur, un code de programme correspondant à la variante de modèle étant téléchargé de l'ordinateur vers l'unité centrale de traitement logicielle ;
exécuter un programme de simulation, un signal à traiter par l'unité centrale de traitement logicielle selon la variante de modèle étant simulé et transmis, par l'intermédiaire d'une interface correspondante, de l'ordinateur à l'unité centrale de traitement logicielle programmée sur le module logique programmable,
traiter le signal d'entrée par l'unité centrale de traitement logicielle ;
saisir et mémoriser des données de profilage de l'unité centrale de traitement logicielle en ce qui concerne le traitement du signal d'entrée, **caractérisé en ce que**
des simulations de type processeur dans la boucle sont effectuées,
une pluralité de configurations d'unité centrale de traitement logicielle sont créées avec différentes étendues de configuration, que des simulations sont effectuées pour différentes combinaisons de variante de modèle et de configurations d'unité centrale de traitement logicielle,
sachant que les données de profilage comprennent au moins l'une des grandeurs suivantes : taux d'utilisation de la mémoire RAM et/ou ROM, taux d'utilisation de la pile, temps d'exécution requis ou précision de l'opération de calcul, et,
en outre, l'étape consistant à déterminer si la fonctionnalité représentée dans la variante de modèle peut être calculée par le seul module logique programmable en temps réel et avec une précision requise, est réalisée, les données de profilage saisies servant de base d'évaluation.

2. Procédé pour l'optimisation du déploiement d'un module logique programmable destiné à être utilisé dans une unité d'appareil de commande électronique pour véhicules selon l'une quelconque des revendications précédentes, dans lequel les configurations d'unité centrale de traitement logicielle diffèrent en ce qui concerne une utilisation d'opérations en virgule fixe ou en virgule flottante.

3. Procédé pour l'optimisation du déploiement d'un module logique programmable destiné à être utilisé dans une unité d'appareil de commande électronique pour véhicules selon l'une quelconque des revendications précédentes, dans lequel les configurations d'unité centrale de traitement logicielle diffèrent en ce qui concerne la mémoire cache pour des instructions et des données et/ou la longueur des pipelines.

4. Procédé pour l'optimisation du déploiement d'un module logique programmable destiné à être utilisé dans une unité d'appareil de commande électronique pour véhicules selon l'une quelconque des revendications précédentes, dans lequel les configurations d'unité centrale de traitement logicielle diffèrent en ce qui concerne une utilisation de différentes opérations de base arithmétiques et logiques.

5. Procédé pour l'optimisation du déploiement d'un module logique programmable destiné à être utilisé dans une unité d'appareil de commande électronique pour véhicules selon l'une quelconque des revendications précédentes, le procédé comprenant en outre :
sélection automatique d'une configuration optimale de l'unité centrale de traitement logicielle et de la variante de modèle correspondante selon des critères prédéterminés concernant l'étendue de configuration de l'unité centrale de traitement logicielle et les données de profilage, génération parfaitement adaptée d'un code de programme d'appareil de commande correspondant à l'aide de la variante de modèle sélectionnée.

6. Système pour déterminer une configuration de déploiement optimale d'un module logique programmable destiné à être utilisé dans une unité d'appareil de commande électronique pour véhicules, comprenant :
un module logique programmable qui est disposé sur une carte imprimée de développement et comporte une unité centrale de traitement logicielle et/ou une surface résiduelle non utilisée ;
un ordinateur pour exécuter un programme de simulation correspondant à une variante de modèle de l'unité de commande, le programme de simulation représentant la fonctionnalité de l'unité de commande et simulant des signaux d'entrée qui doivent être traités par une unité centrale de traitement logicielle sur le module logique programmable ;
des moyens pour instancier une unité centrale de traitement logicielle avec une étendue de configuration déterminée sur le module logique programmable, l'unité centrale de traitement logicielle occupant une surface du module logique programmable correspondant à l'étendue de configuration, des moyens pour télécharger un code de programme correspondant à la variante de modèle de l'ordinateur sur l'unité centrale de traitement logicielle ;
des moyens pour transmettre un signal d'entrée généré lors de l'exécution du programme de simulation de l'ordinateur à l'unité centrale de traitement logicielle instanciée sur le module logique programmable, en vue de son traitement ;
des moyens pour saisir des données de profilage de l'unité centrale de traitement logicielle en ce qui concerne le traitement du signal d'entrée ;
des moyens pour transférer les données de profilage saisies de l'unité centrale de traitement logicielle à l'ordinateur ;
**caractérisé par**
des moyens pour créer une pluralité de configurations d'unité centrale de traitement logicielle avec différentes étendues de configuration,
des moyens pour exécuter des simulations de type processeur dans la boucle pour différentes combinaisons de variante de modèle et de configurations d'unité centrale de traitement logicielle, et
des moyens pour déterminer si la fonctionnalité représentée dans la variante de modèle peut être calculée par le seul module logique programmable en temps réel et avec une précision requise, les données de profilage saisies servant de base d'évaluation, sachant que les données de profilage comprennent au moins l'une des grandeurs suivantes : taux d'utilisation de la mémoire RAM et/ou ROM, taux d'utilisation de la pile, temps d'exécution requis ou précision de l'opération de calcul.
